# EUROPÄISCHE PATENTANMELDUNG

(11) **EP 0 619 634 A1**
(43) Veröffentlichungstag der Anmeldung: **12.10.1994**
(21) Anmeldenummer: 94105009.8
(22) Anmeldetag: 30.03.1994
(51) Int. Cl.: H02G 3/14

(54) **Einrichtung zur lösbaren Verbindung eines Gehäuses mit einem Deckel**

(30) Priorität: 06.04.1993 DE 4311183
(71) Anmelder: ABB PATENT GmbH, D-68309 Mannheim (DE)
(72) Erfinder: Berendsen, Albertus, NL-6713 AV Ede (NL)
(74) Vertreter: Rupprecht, Klaus, Dipl.-Ing.

(57) **Zusammenfassung**

Es wird eine Einrichtung zur lösbaren Verbindung eines Gehäuses mit einem Deckel vorgeschlagen, bei der das Gehäuse (21) mindestens eine federnde Zunge (25,25') aufweist, an deren Endteil ein Riegelnocken (24,24') angeformt ist. Dieser Riegelnocken (24,24') ist mit einer Schrägfläche (23) und einer Verriegelungsfläche (26,26') versehen. Der Deckel (1) weist mindestens einen Riegelnocken (3,3') auf, der mit einer Verriegelungsfläche (5,5') versehen ist. Der Boden (14) des Deckels ist am Ort des Riegelnockens (3,3') mit einer Öffnung (6) versehen. Zur Verriegelung von Gehäuse (21) und Deckel (1) gleitet die Schrägfläche (23) des Riegelnockens (24) des Gehäuses (21) entlang des Riegelnockens (3,3') des Deckels (1) bis die Verriegelungsflächen (26,5,26',5') von Gehäuse und Deckel federnd ineinandergreifen. Zur Entriegelung von Gehäuse (21) und Deckel (1) drückt ein durch die Öffnung (6) gestecktes Werkzeug auf die Schrägfläche (23) des Riegelnockens (24,24') des Gehäuses (21), wodurch die Verriegelungsflächen (26,5,26',5') gegen die Federkraft der Zunge (25,25') voneinander entfernt und entriegelt werden.

## Beschreibung

Die Erfindung bezieht sich auf eine Einrichtung zur lösbaren Verbindung eines Gehäuses mit einem Deckel und kann beispielsweise bei Verteilerdosen der Niederspannungs-Installationstechnik verwendet werden.

Zur Befestigung eines Deckels auf einem Gehäuse sind vielfältige Ausführungsvarianten, insbesondere in Form von Schraub- oder Schnappverbindungen, allgemein bekannt. Dabei haben Schnappverbindungen oft den Vorteil einer sehr einfachen Montage des Deckels auf dem Gehäuse, da kein Werkzeug eingesetzt werden muß. Zur Demontage ist jedoch aus Sicherheitsgründen für die meisten Anwendungen ein Werkzeugeinsatz erforderlich. Manche der allgemein bekannten Schnappverbindungen lassen sich auch ohne Werkzeug öffnen, was sicherheitstechnisch bedenklich bzw. unzulässig ist, wenn bei offenem Gehäuse potentialbehaftete Bauteile (z.B. Klemmen) frei zugänglich sind. Bei manchen mit einem Werkzeug zu öffnenden Gehäusen ist es erforderlich, daß das Werkzeug seitlich des Gehäuses eingesetzt wird (um beispielsweise eine Spaltöffnung zwischen Gehäuse und Deckel zu erweitern). Dies ist nachteilig, da rings um das Gehäuse relativ viel Raum frei bleiben muß und nicht mit anderen Bauteilen bestückt werden kann.

Der Erfindung liegt die Aufgabe zugrunde, eine Einrichtung zur lösbaren Verbindung eines Gehäuses mit einem Deckel der eingangs genannten Art anzugeben, die einerseits ein Verschließen des Gehäuses ohne Werkzeugeinsatz ermöglicht und die andererseits zum Öffnen des Gehäuses ein Werkzeug erfordert, wobei der Werkzeugeinsatz frontal vom Deckel aus und nicht seitlich des Gehäuses zu erfolgen hat.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß eine Schnappverbindung aufgezeigt wird, die eine sehr einfache und leicht handhabbare Deckelmontage auf dem Gehäuse gewährleistet und keinesfalls ohne Werkzeugeinsatz gelöst werden kann, und zwar auch nicht bei Manipulierung, beispielsweise durch Drücken auf die Seitenwände des Gehäuses oder Deckels. Die Bauteile der Schnappvorrichtung befinden sich ohne Ausnahme im Innenraum des Gehäuses, so daß die Außenflächen des Gehäuses und Deckels glatt ausgebildet sein können. Da zur Demontage des Deckels das Werkzeug frontal, d.h. senkrecht zum Deckelboden eingreift, kann das Gehäuse auch bei beengten Platzverhältnissen ohne seitlichen Raum verwendet werden. Es ist möglich, mehrere Gehäuse eng benachbart nebeneinander zu montieren, da kein seitlicher Abstand zwischen den einzelnen Gehäusen eingehalten werden muß.

Vorteilhafte Ausgestaltungen der Erfindung sind in den Unteransprüchen gekennzeichnet.

Die Erfindung wird nachstehend anhand des in der Zeichnung dargestellten Ausführungsbeispieles erläutert. Es zeigen:
- Figur 1: eine Sicht auf ein Gehäuse,
- Figur 2: einen Schnitt A-A durch das Gehäuse,
- Figur 3: eine Seitenansicht eines Gehäuses,
- Figur 4: einen Schnitt C-C durch eine federnde Zunge,
- Figur 5: eine Sicht auf die Außenseite eines Deckels,
- Figur 6: eine Sicht auf die Innenseite eines Deckels,
- Figur 7: einen Schnitt B-B durch einen Deckel,
- Figur 8: eine vergrößerte Darstellung eines Details I gemäß Figur 7,
- Figur 9: eine vergrößerte Darstellung eines Details I gemäß Figur 6,
- Figur 10: eine vergrößerte Darstellung eines Details II gemäß Figur 6,
- Figur 11: eine Schnittdarstellung des Details II gemäß Figur 6,
- Figur 12: eine Detaildarstellung gemäß Figur 8 bei Verriegelung,
- Figur 13: eine Detaildarstellung gemäß Figur 11 bei Verriegelung,
- Figur 14: eine Variante bezüglich der Ausbildung der Verriegelungsflächen.

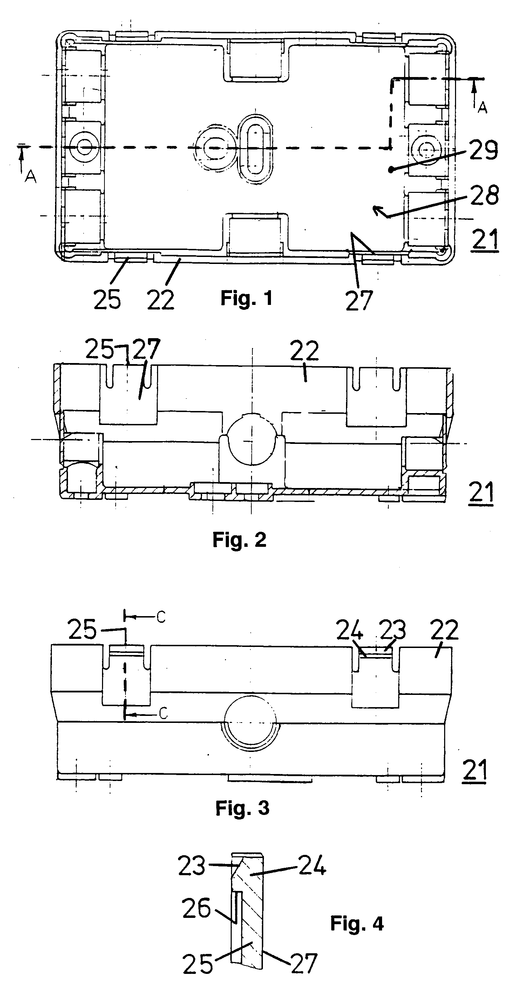

In Figur 1 ist eine Sicht auf ein Gehäuse dargestellt. Es ist zu erkennen, daß die Seitenwände 22 des Gehäuses 21 an mehreren Stellen - im Ausführungsbeispiel an vier Stellen - unterbrochen sind, wobei sich jeweils federnde Zungen 25 in den hierdurch gebildeten Aussparungen befinden. Die zum durch den Gehäuseboden 29 und die Seitenflächen 22 gebildeten Gehäuseinnenraum 28 gerichteten Seitenflächen der federnden Zungen 25 sind mit Ziffer 27 bezeichnet.

In Figur 2 ist ein Schnitt A-A durch das Gehäuse dargestellt. Die Schnittfläche A-A ist in Figur 1 gekennzeichnet. Es sind die Seitenwände 22 des Gehäuses 21 sowie federnde Zungen 25 mit ihren zum Gehäuseinnenraum gerichteten Seitenflächen 27 zu erkennen.

In Figur 3 ist eine Seitenansicht eines Gehäuses dargestellt. Es sind eine Seitenwand 22 des Gehäuses 21 sowie federnde Zungen 25 zu erkennen. Die Endteile der federnden Zungen 25 sind als Riegelnocken 24 ausgebildet, die nach außen gerichtete Schrägflächen 23 aufweisen.

In Figur 4 ist ein Schnitt C-C durch eine federnde Zunge dargestellt. Die Schnittfläche C-C ist in Figur 3 gekennzeichnet. Die zum Gehäuseinnenraum gerichtete Seitenfläche 27 der federnden Zunge 25 ist glatt (d.h. ohne Abstufungen) ausgebildet. Die nach außen gerichtete Seitenfläche der federnden Zunge 25 ist jedoch im Endteil der Zunge derart verdickt und abgestuft, daß ein Riegelnocken 24 geformt wird, der eine parallel zum Gehäuseboden 29 verlaufende Verriegelungsfläche 26 (Abstufung) sowie eine Schrägfläche 23 aufweist. Durch die Schrägfläche 23 verjüngt sich das Endteil der federnden Zunge 25 bzw. des Riegelnockens 24.

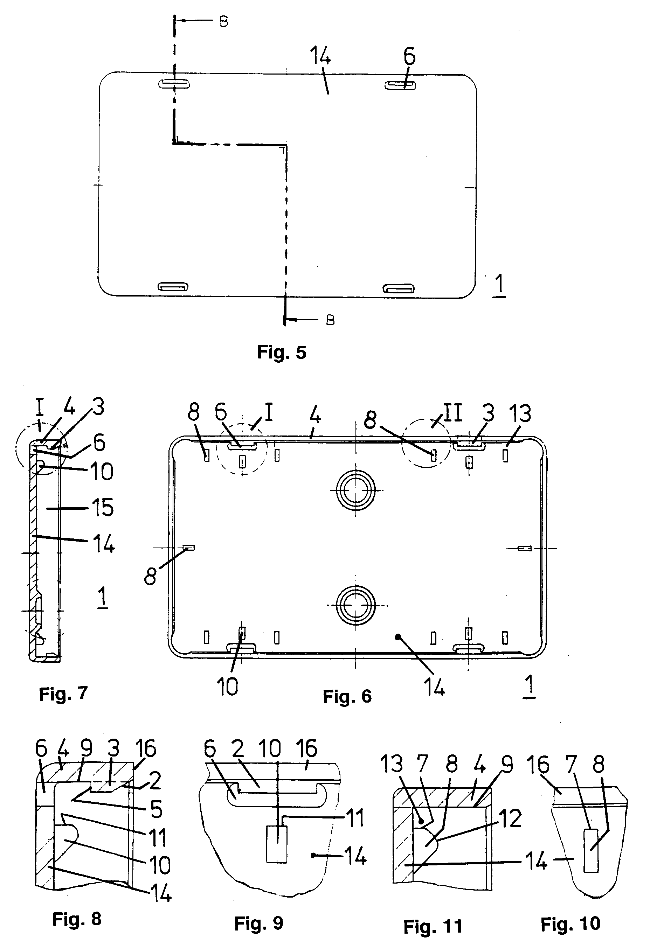

In Figur 5 ist eine Sicht auf die Außenseite eines Deckels dargestellt. Es ist zu erkennen, daß der Deckelboden 14 des Deckels 1 mit mehreren Öffnungen 6 - im Ausführungsbeispiel mit vier Öffnungen 6 - in der Nähe der Außenkanten versehen ist.

In Figur 6 ist eine Sicht auf die Innenseite eines Deckels dargestellt. Die Öffnungen 6 im Deckelboden 14 des Deckels 1 sind zu erkennen. An den Deckelboden 14 sind die Seitenwände 4 angeformt. Am Ort der Öffnungen 6 weisen die Innenflächen der Seitenwände 4 Riegelnocken 3 auf. Diese Riegelnocken 3 greifen in die Riegelnocken 24 des Gehäuses 21 ein. Im Deckelboden 14 sind jeweils in der Nähe der Riegelnocken 3 (und in vorgebbarem Abstand von diesen) Stützrippen 10 angeformt. Ferner sind mehrere Verschlußrippen 8 am Deckelboden 14 derart angebracht, daß sich ein Spalt 13 zwischen einer Verschlußrippe 8 und einer Seitenwand 4 des Deckels 1 ausbildet, der zur Aufnahme und Abstützung einer Seitenwand 22 des Gehäuses 21 geeignet ist.

In Figur 7 ist ein Schnitt B-B durch einen Deckel dargestellt. Die Schnittfläche B-B ist in Figur 5 gekennzeichnet. Durch die Seitenwände 4 des Deckels 1 und den Deckelboden 14 wird ein Deckelinnenraum 15 gebildet. In diesen Deckelinnenraum 15 ragen die an die Seitenwände 4 angeformten Riegelnocken 3 und die am Deckelboden 14 angeformten Stützrippen 10. Der Deckelboden 14 wird durch die Öffnungen 6 durchbrochen.

In Figur 8 ist eine vergrößerte Darstellung eines Details I gemäß Figur 7 (Schnitt durch einen Deckel) dargestellt. Wie zu erkennen ist, weist der an die Innenfläche 9 der Seitenwand 4 angeformte Riegelnocken 3 in einem vorgebbaren Abstand vom Deckelboden 14 eine parallel zum Deckelboden 14 verlaufende Verriegelungsfläche 5 auf. Zur Stirnfläche 16 der Seitenwand 4 hin verjüngt sich der Riegelnocken 3 in Form einer Schrägfläche 2. Durch die Öffnung 6 im Deckelboden 14 blickt man auf die Verriegelungsfläche 5 des Riegelnockens 3. Figur 8 zeigt ferner eine Stützrippe 10, deren parallel zur Seitenwand 4 verlaufende Andrückfläche 11 sich mit vorgebbarem Abstand zur Innenfläche 9 der Seitenwand 4 befindet.

In Figur 9 ist eine vergrößerte Darstellung eines Details I gemäß Figur 6 (Sicht auf die Deckel-Innenseite) dargestellt, und zwar eine Sicht auf die Stirnfläche 16 der Seitenwand 4, die Schrägfläche 2 des Riegelnockens 3, die Öffnung 6 und die am Deckelboden 14 befindliche Stützrippe 10. Die Lage der Andrückfläche 11 der Stützrippe 10 ist angedeutet.

In Figur 10 ist eine vergrößerte Darstellung eines Details II gemäß Figur 6 (Sicht auf die Deckel-Innenseite) dargestellt , und zwar eine Sicht auf die Stirnfläche 16 der Seitenwand 4 und die am Deckelboden 14 befindliche Verschlußrippe 8. Die Lage einer Andrückfläche 7 der Verschlußrippe 8 ist angedeutet (siehe Figur 11).

In Figur 11 ist ein Schnitt des Details II gemäß Figur 6 vergrößert dargestellt (siehe auch Figur 10). Es sind der Deckelboden 14 mit angeformter Verschlußrippe 8 zu erkennen. Die Verschlußrippe 8 weist eine parallel zur Innenfläche 9 der Seitenwand 4 verlaufende Andrückfläche 7 auf, an die sich eine Schrägfläche 12 anschließt. Zwischen den Flächen 9 und 7 bildet sich ein Spalt 13 aus, der zum Eingriff der Seitenwand 22 des Gehäuses geeignet ist. Die Schrägfläche 12 erleichtert das Einführen der Seitenwand 22 in den Spalt 4.

Zum Verschluß des Gehäuses wird der Deckel 1 auf das Gehäuse 21 gedrückt. Dabei gleiten die Schrägflächen 23 der Riegelnocken 24 und die Schrägflächen 2 der Riegelnocken 3 aufeinander und die federnden Zungen 25 werden in Richtung Innenraum 28 des Gehäuses gedrückt, bis der Deckel 1 völlig angepreßt ist und die Verriegelungsflächen 26 der Riegelnocken 24 sowie Verriegelungsflächen 5 der Riegelnocken 3 ineinandergreifen. Für dieses "Einschnappen" und gegenseitiges Verriegeln ist es vorteilhaft, wenn die federnden Zungen 25 eine vorgebbare, nach außen hin gerichtete Vorspannung aufweisen.

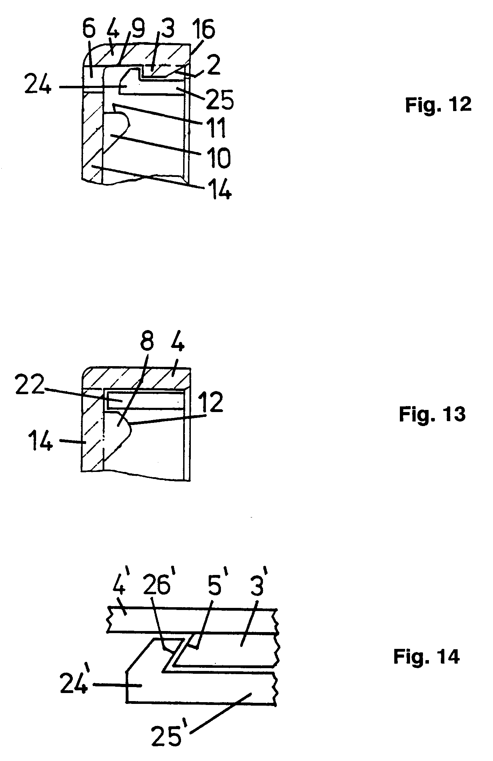

In Figur 12 ist hierzu eine Detaildarstellung gemäß Figur 8 für den Zustand bei Verriegelung gezeigt. Zusätzlich ist die federnde Zunge 25 mit Riegelnocken 24 zu erkennen.

Während des Andrückens des Deckels 1 an das Gehäuse 21 werden gleichzeitig die Seitenwände 22 des Gehäuses 21 in die Spalten 13 zwischen Innenflächen 9 der Seitenwände 4 und Andrückflächen 7 der Verschlußrippen 8 gepreßt.

In Figur 13 ist hierzu eine Detaildarstellung gemäß Figur 11 für den Zustand bei Verriegelung gezeigt. Zusätzlich zur Figur 8 ist die Seitenwand 22 des Gehäuses 21 zu erkennen.

Auf diese Weise entsteht eine relativ starre Verbindung zwischen den Seitenwänden 4, 22 von Deckel 1 und Gehäuse 21. Gleichzeitig wird verhindert, daß infolge einer Krafteinwirkung auf die Seitenwände 4 oder auf Deckelboden 14 eine Entriegelung ermöglicht wird. Bei einer Krafteinwirkung mit einer Wirkrichtung vom Innenraum 28 des Gehäuses nach außen (beispielsweise verursacht durch eine Vielzahl im Gehäuseinnenraum befindlicher Drähte) wird die Verriegelung durch die auf die Seitenwände 22 und die federnden Zungen 25 einwirkenden, nach außen gerichteten Kräfte verstärkt.

Die Verriegelung des Deckels 1 mit dem Gehäuse 21 kann mittels eines durch die Öffnung 6 im Deckelboden eingeführten Werkzeuges - beispielsweise einer Schraubendreherklinge - gelöst werden. Das Werkzeug drückt dabei gegen die Schrägfläche 23 des Riegelnockens 24, wodurch der Riegelnocken 24 weg von der Innenfläche 9 der Seitenwand 4 in Richtung der Stützrippe 10 bewegt wird. Die Entriegelung der Verriegelungsflächen 5, 26 erfolgt, bevor sich die Seitenfläche 27 der federnden Zunge 25 und die Andrückfläche 7 der Stützrippe 10 berühren. Die Stützrippe 10 verhindert eine Überdehnung der mittels des Werkzeuges zurückgepreßten federnden Zunge über den zugelassenen elastischen Bereich hinaus.

In Figur 14 ist eine Variante bezüglich der Ausbildung der Verriegelungsflächen dargestellt. Bei dieser Variante sind die Winkel zwischen Verriegelungsfläche 5' des Riegelnockens 3' und Seitenwand 4' des Deckels sowie zwischen Verriegelungsfläche 26' des Riegelnockens 24' und federnder Zunge 25' nicht mehr rechtwinklig, sondern spitzwinklig. Hierdurch wird die Verriegelungswirkung verstärkt.

Ein Vorteil der Schnappeinrichtung besteht auch darin, daß die Verriegelungsfläche 5, 5' durch die Öffnung 6 hindurch mittels eines Bearbeitungswerkzeuges gefertigt werden kann. Scharf konturierte Verriegelungsflächen 5, 5', 26, 26' gewährleisten eine optimale Verriegelung.

## Patentansprüche

1. Einrichtung zur lösbaren Verbindung eines Gehäuses mit einem Deckel, dadurch gekennzeichnet,
- daß das Gehäuse (21) mindestens eine federnde Zunge (25,25') aufweist, an deren Endteil ein Riegelnocken (24,24') angeformt ist,
- daß dieser Riegelnocken (24,24') mit einer Schrägfläche (23) und einer Verriegelungsfläche (26,26') versehen ist,
- daß der Deckel (1) mindestens einen Riegelnocken (3,3') aufweist, der mit einer Verriegelungsfläche (5,5') versehen ist,
- und daß der Boden (14) des Deckels am Ort des Riegelnockens (3,3') mit einer Öffnung (6) versehen ist,
- wobei zur Verriegelung von Gehäuse (21) und Deckel (1) die Schrägfläche (23) des Riegelnockens (24) des Gehäuses (21) entlang des Riegelnockens (3,3') des Deckels (1) gleitet, bis die Verriegelungsflächen (26,5,26',5') von Gehäuse und Deckel federnd ineinandergreifen,
- und wobei zur Entriegelung von Gehäuse (21) und Deckel (1) ein durch die Öffnung (6) gestecktes Werkzeug auf die Schrägfläche (23) des Riegelnockens (24,24') des Gehäuses (21) drückt, wodurch die Verriegelungsflächen (26,5,26',5') gegen die Federkraft der Zunge (25,25') voneinander entfernt und entriegelt werden.

2. Einrichtung nach Anspruch 1, dadurch gekennzeichnet, daß der Riegelnocken (3,3') des Deckels (1) ebenfalls eine Schrägfläche (2) aufweist, die entlang der Schrägfläche (23) des Riegelnockens (24,24') der federnden Zunge (25,25') gleitet.

3. Einrichtung nach Anspruch 1 und/oder 2, dadurch gekennzeichnet, daß der Boden (14) des Deckels (1) mit mindestens einer Stützrippe (10) versehen ist, gegen deren Andrückfläche (11) der Riegelnocken (24,24') der federnden Zunge (25,25') während der Entriegelung preßt, sobald die Verriegelungsflächen (26,5,26',5') entriegelt sind.

4. Einrichtung nach einem der Ansprüche 1 bis 3, dadurch gekennzeichnet, daß sich der Riegelnocken (3,3') an einer Seitenwand (4) des Deckels (1) und die federnde Zunge (25,25') mit Riegelnocken (24,24') an einer Seitenwand (22) des Gehäuses (21) befinden.

5. Einrichtung nach Anspruch 4, dadurch gekennzeichnet, daß der Boden (14) des Deckels (1) mit mindestens einer, nahe der Stützrippe (10) befindlichen Verschlußrippe (8) versehen ist, wodurch ein Spalt (13) zwischen Verschlußrippe (8) und Seitenwand (4) des Deckels (1) gebildet wird, in den eine Seitenwand (22) des Gehäuses (21) bei Veriegelung eingreift.

6. Einrichtung nach Anspruch 5, dadurch gekennzeichnet, daß die Verschlußrippe (8) mit einer Schrägfläche (12) versehen ist, entlang der eine Seitenwand (22) des Gehäuses (21) bei Verriegelung gleitet.

7. Einrichtung nach einem der Ansprüche 1 bis 6, dadurch gekennzeichnet, daß die Verriegelungsfläche (26) des Riegelnockens (24) der federnden Zunge (25) rechtwinklig bezüglich der federnden Zunge (25) und die Verriegelungsfläche (5) des Riegelnockens (3) des Deckels (1) parallel bezüglich des Deckelbodens (14) angeordnet sind.

8. Einrichtung nach einem der Ansprüche 1 bis 6, dadurch gekennzeichnet, daß die Verriegelungsfläche (26') des Riegelnockens (24') der federnden Zunge (25') spitzwinklig bezüglich der federnden Zunge (25') und die Verriegelungsfläche (5') des Riegelnockens (3') des Deckels (1) spitzwinklig bezüglich des Deckelbodens (14) angeordnet sind.

9. Einrichtung nach einem der Ansprüche 1 bis 8, gekennzeichnet durch zwei oder mehr Anordnungen mit Riegelnocken (24,3,24',3'), Schrägflächen (23), Verriegelungsflächen (26,5,26',5') und Öffnungen (6).
